# EUROPEAN PATENT SPECIFICATION

(11) **EP 0 748 037 B1**
(45) Date of publication and mention of the grant of the patent: **08.08.2001**
(21) Application number: 96107945.6
(22) Date of filing: 18.05.1996
(51) Int. Cl.: H02P 6/14, H02M 1/08, H02P 6/08, H02P 7/62

(54) **Electronic motor controller with isolated gate drive and distributed power supply**
Elektronischer Motorregler mit isolierter Gateansteuerung und verteilter Stromversorgung
Contrôleur de moteur électronique avec commande de grille isolée et alimentation en courant distribuée

(30) Priority: 07.06.1995 US 472812; 07.06.1995 US 473214
(43) Date of publication of application: 11.12.1996
(73) Proprietor: KOLLMORGEN CORPORATION, Waltham, MA 02154 (US)
(72) Inventor: Vlahu, Saso P., Munster, Indiana 46321 (US)
(74) Representative: Königseder-Egerer, Claudia D.

(56) References cited:
- EP-A- 0 206 104
- EP-A- 0 447 989
- DE-A- 3 509 617
- DE-A- 3 523 666

## Description

This invention relates to compact, high efficiency, high frequency, PWM electronic motor controllers with isolated gate drives for IGBT power transistors and to such controllers with distributed power supply.

### BACKGROUND OF THE INVENTION

US-A-4,686,437 describes a motor control system whereby a microprocessor or similar electronics is used to control electric motors. The sensitive electronics are coupled to the motor via a power transistor switching stage wherein the transistors operate in on/off fashion to control the current flow to the motor windings in accord with control signals from the microprocessor. The microprocessor receives feedback from the motor indicating rotor position and other controllable parameters. The microprocessor may also receive command signals usable for servo control. The command signals and the feedback signals are compared to determine the frequency, amplitude and phase for the winding energization, and the rotor position feedback is used to determine the proper commutation of the winding excitation. The microprocessor, either alone or with other components, provides on/off control signals to the power stages which, in turn, supply current to the windings with the desired amplitude, frequency and phase commutated according to the rotor position.

US-A-4,447,771 and US-A-4,490,661 disclose motor control systems in which digital electronics control power switching transistors via a pulse width modulator (PWM) so that the excitation current to the motor is a function of the pulse width. Both patents disclose techniques for controlling the phase angle of the excitation current relative to the rotor position to improve the torque efficiency of the system.

In such systems used to control large motors isolation is necessary between the sensitive electronic controller and the brute force power stages that drive the motor. Most present day systems employ optical coupling which provides a high degree of isolation in the present controller designs which operate at a PWM switching rate of about 2 KHz.

There is an ever present desire to provide smaller and less costly controllers and controllers with high overall system efficiency. The invention provides those advantages for any size motor. However, the advantages are more pronounced for large motors in the range of 10 to 150 horse-power and are even more so for motors in the range above 150 horsepower. In the higher horsepower ranges, inefficient use of components and inefficient overall system design directly translate into high controller and high usage costs.

One approach to smaller and less costly controllers is to increase the switching frequency of the PWM power stage. A high speed driving circuit for MOSFET transistors has been disclosed in EP-A-447989 describing, inter alia, a coupling transformer which is driven on the driving logic side and has a turns ratio of 2:1 and power supplies which operate at 100 kHz. Furthermore. EP-A-206104 describes an inverter including a pulse transformer having a primary winding and a first and second secondary winding. In theory at least, higher switching frequencies should make it possible to control the needed power for large motors using smaller and less expensive components. However, the problems associated with operating the power stages at higher switching frequencies have proven to be either insolvable or prohibitively costly both in space and money. High frequency noise can bleed off power from the system and seriously affect the system efficiency. Noise of the common mode variety (noise that goes up and down together on a parallel conductor pair) can be particularly difficult to detect and even more difficult to eliminate.

### SUMMARY OF THE INVENTION

It is an object of the invention to provide improved isolation between the sensitive electronic stages and the associated power stages.

It is another object of the invention to provide effective isolation coupling between the electronic stages and the associated power stages in a motor control system where the power stage can operate at a switching rate in the range of above 6000 Hz.

Still another object of the invention is to provide a motor controller operating at a high power switching rate with little high frequency power loss and negligible noise generation.

A still further object of the invention is to provide a distributed power supply for a motor controller operating at a high switching rate with little high frequency power loss and negligible noise generation.

Yet another object of the invention is to provide a motor controller with higher system efficiency, i.e., maximum torque, relative to energy applied to the controller.

These and other objects are achieved by the controller as claimed in Claims 1 to 7.

Optical coupling which provides effective coupling isolation at low switching rates has too much time delay for effective operation in the high switching frequency range. Furthermore, switching at a 6000 Hz rate can generate transients as high as 100 MHz which are not effectively decoupled with the optical devices. Known high frequency, electronic transformer coupling is too expensive and complicated for effective use in a motor controller.

In the invention, a pulse transformer in the form of a dynamic coupling inductance is used including spaced apart primary and secondary windings wound around a common high permeability core. The flux return path for flux through the core is configured to surround the windings. The core is configured so that it is saturable in normal operation. The windings are spaced as far apart as possible to minimize the inter-winding capacitance. In the preferred embodiment, the windings are wound using a small number of turns and small wires to minimize the surface area of the winding to thereby reduce winding to shell and winding to winding capacitance.

If a rectangular pulse is applied to the primary winding of the pulse transformer, a positive spike appears at the secondary winding corresponding to the rise time, and a negative spike appears according to the fall time. The rise time of the positive spike occurs while the core is being driven into saturation and the windings are coupled to one another. Once saturation is reached, the windings are decoupled. A similar operation takes place during the fall time. With the design according to the concept of the invention, turn on and turn off times for pulses passing through the pulse transformer are as little as 100 nanoseconds which is about 10 times faster than could be accomplished using optical coupling.

Rectangular pulses from a microprocessor and other electronic stages pass through the saturable pulse transformer as a positive and a negative spike pair which is supplied to a Schmitt trigger that reconstitutes the rectangular pulse for control of the power transistors. With the arrangement according to the invention, only the leading and trailing edges of the pulses pass through the pulse transformer. As a result, power stage switching can be achieved at the rate of 10A/100 nanoseconds. Using conventional components, switching for large motor control systems can be on the order of about 250 to about 450 nanoseconds, depending on the motor size. Faster switching speeds, as low as 150 nanoseconds, can be achieved by using special high speed components. Double pulsing problems (where a turn-off command is received before the power stage is fully turned on) are virtually eliminated by the high speed switching according to the invention.

The isolation coupling between the electronic and power stages results in a very high. rejection of common mode noise and elimination of the related energy absorption. Contrary to conventional design, the primary and secondary windings are located on a ferrite core and separated as far as possible to minimize inter-winding capacitance. A minimum number of winding turns and a small diameter wire are used for the winding to minimize the conductive surface area. Although this structure provides relatively poor magnetic coupling between the windings, it is sufficient since only the leading and trailing edges of the pulses actually pass through the transformer.

In a preferred embodiment, the power supplies for the high frequency control system according to the invention must also isolate the sensitive electronic stages from the power stages. This is achieved through the use of a separate floating supply for each set of drive stages for each of the power transistors. A typical three-phase system includes a pair of IGBT (Isolated Gate Bipolar Transistors) power transistors for each phase for a total of six power transistors. Each of the power transistors has a separate gate drive circuit, and each of the gate drive circuits has a separate power supply. The floating supplies preferably operate at a high frequency such as 60000 Hz to reduce transformer size. These floating supplies are designed for an open loop control to limit the supply voltage without using regulators which tend to convey noise and introduce undesirable regulating time delays. Separate transformers are used to supply the floating supplies (on the secondary side of the isolating pulse transformers) and the analog control electronics (on the primary side of the isolating pulse transformers) to maintain the isolation between the electronic and power stages. The digital electronics and the analog electronics are supplied from separate transformers and each have separate return paths with ground toed together at the supply.

### BRIEF DESCRIPTION OF THE DRAWINGS

The foregoing and other objects are achieved with embodiments as described in the following specification which includes the drawings as follows:
Fig. 1 is a block diagram showing the overall layout of a motor controller according to the invention.
Fig. 2 is a cross-sectional view of the high frequency pulse transformer according to the invention.
Fig. 3 is a schematic diagram of the electronic stages connected to the primary side of the pulse transformer.
Fig. 4 is a schematic diagram of the gate drive including the pulse transformer and Schmitt trigger circuit connected to the secondary side of the pulse transformer.
Fig. 5 is a schematic diagram of the power supplies for the motor controller.
Fig. 6 is a schematic diagram of the independent floating ground supplies for the gate drives.

### DETAILED DESCRIPTION

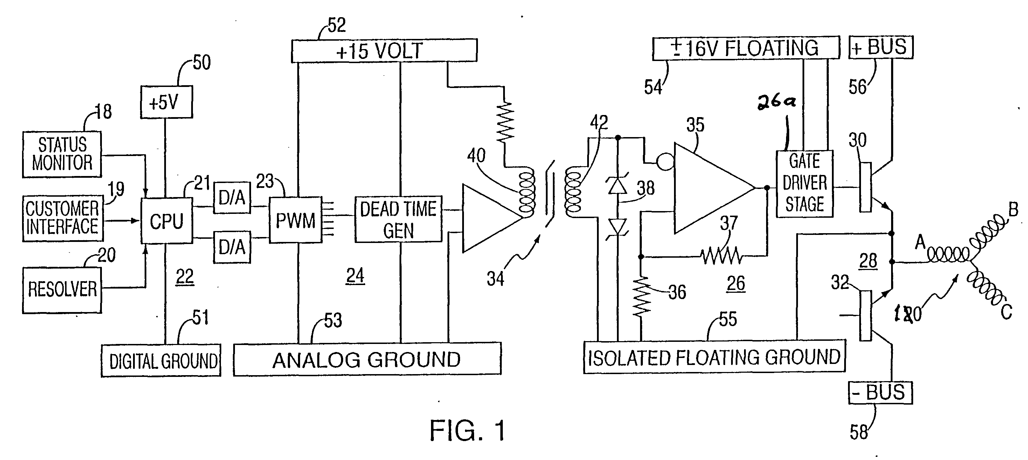

The motor controller illustrated in Fig. 1 controls a brushless motor 10 having a three phase stator winding including winding phases A, B and C. The winding phases are each displaced by 120 electrical degrees. Although the invention can be used with any type of brushless motor, it is particularly useful with a motor having three phase stator windings operating in the current pulse range above 2000 Hz and preferably in the range of 6000 to 20000 Hz or higher. Although the invention is useful with any size motor, the advantages are particularly important in controlling large and very large motors.

The motor controller includes a digital section **22** including a central processing unit **21** (CPU), such as a microprocessor, to receive control commands and motor feedback signals to generate sinusoidal signals corresponding to the frequency, phase and amplitude of the motor excitation currents. The signals from the digital section pass through an analog section **24** including a pulse width modulator **23** (PWM) to convert the sinusoidal signals into corresponding pulse trains of pulses with varying width. The pulse trains pass through a gate drive **26** to the main power transistors **28.**

The digital section generates two sinusoidal signals for the three phase motor excitation, the third signal being derived in analog section **24** as the sum of the other two phases. The analog section generates complimentary pulse trains for each of the three phases, or a total of six pulse trains, only one of which is shown in Fig. 1. The six pulse trains each pass through a separate gate drive (only one being shown) to control the conductive state of the six power transistors (only two of which are shown).

The microprocessor can be programmed to produce a sinusoidal excitation current of any desired phase, amplitude and frequency to almost any type of motor including synchronous, induction or reluctance motors. The system can also be programmed to calculate excitation phase angle for maximum torque producing efficiency according to the aforementioned US-Patents.

In the operation of the controller it is essential that the power stages, including gate drives **26** and power transistor stages **28,** be isolated from the sensitive electronic stages of digital section **22** and of analog section **24**. For a conventional controller operating at a PWM rate of about 2000 Hz, the necessary isolation can be achieved with an optical coupler. But to reduce the size of components, and to achieve other advantages, a higher PWM pulse repetition rate in the range of 6000 to 20000 Hz is used.

To achieve the necessary isolation without prohibitive leakage losses and noise problems, a specially constructed ferrite core transformer **34** with extremely low inter-winding capacitance is used in combination with a Schmitt trigger located in gate drive **26**. When a PWM pulse is applied to the pulse transformer, the leading edge of the pulse drives the core into saturation. While being driven into saturation, primary winding **40** is coupled to secondary winding **42** and produces a sharp spike on the secondary winding. The trailing edge of the applied pulse likewise drives the core out of saturation and produces a sharp negative spike. Comparator **35** and resistors **36** and **37** are connected in a Schmitt trigger configuration. The positive spike turns the trigger on and the negative spike turns the trigger off. Thus, rectangular PWM pulses are passed to the gate drives by passing the leading and trailing edges through transformer **34** to the Schmitt trigger which reconstructs the rectangular pulses.

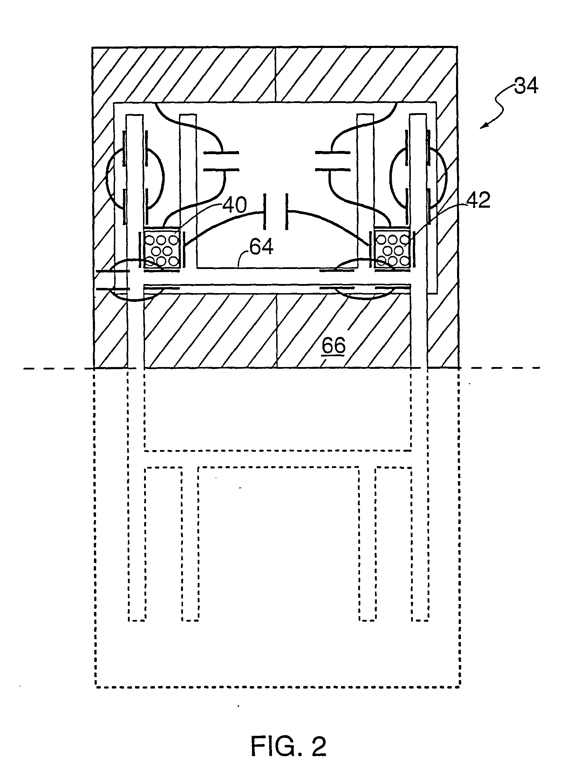

Not only it is necessary to isolate the power stages from the sensitive electronics stages, but it is also necessary to achieve similar isolation in the power supplies for the various stages. The CPU and other components of the digital section **22** require a +5 Volt power supply via conductor **50** and digital ground return **51.** The PWM unit **23** and other components in analog section **24** require a +15 Volt power supply via conductor **52** and analog ground return **53.** Each of the six gate drives **26** require a separate floating +16 Volt power supply via conductor **54** with an isolated floating ground **55.** The power for driving the motor is supplied to the power transistors from a +bus **56** and a -bus **58.** The structure of the various power supplies will be described hereinafter. However, the significant point is that the power stages connected to the output of isolation pulse transformer **34** have separate power supplies isolated from the power supplies for the electronic digital section **22** and analog section **24** connected to the primary winding of the pulse transformer **34.** Pulse transformer **34** is shown in cross-sectional detail in Fig. 2. The transformer includes primary winding **40** and secondary winding **42** wound on a bobbin **64** so that the primary and secondary windings are well separated. A ferrite core **66** passes through the center of the windings and returns the outside of both windings. In other words, the core is constructed to completely surround the windings. Preferably, the core is a two piece structure, as shown in Fig. 2, with the core return path completely surrounding and enclosing the windings to provide self-shielding from radiated noise. The core material should be of a high permeability material to minimize the required number of winding turns. A powder ferric material type W provides good results. Materials such as Suppermeloy or Square 80 provide better results, but are too expensive for most applications.

The pulse transformer is designed to pass rectangular pulses with a repetition rate in the range of 6000 to 20000 Hz which include high frequency transients in the range of 1 MHz to 100 MHz. These high frequency transients can create severe power loss and noise problems. The winding configuration is critical to reducing the power loss and noise problems to acceptable levels. First, the primary and secondary windings are well separated and placed as far apart as possible to minimize the inter-winding capacitance (CWW). As shown in Fig. 2, a spacing of 200-300 mils, on the order of right times the width of the windings, is preferred. This spacing between the windings reduces the inter-winding capacitance (CWW). A higher wire gauge size (i.e., minimum diameter wire) such as gauge **37** is used to minimize winding surface areas which in turn minimize the winding to core capacitance (CWCC) and (CWCS). The number of winding turns is selected to produce an inductance of approximately 1 mH. Ten to thirteen turns have been found to produce the desired results. A larger number of turns increases the ratio relationship between the capacitance and inductance causing self oscillation which is not acceptable. Less than ten turns provide a ratio of capacitance to leakage inductance that attenuates the applied signal to an unacceptable degree. The total leakage capacitance according to the design of the invention has been measured at 0.08 to 0.2 picofarads which results in very low noise and very low high frequency power losses. To be effective, the pulse transformer must have a total leakage capacitance of 5 picofarads, and preferably below 1 picofarad. Conventional designs have been measured in the range of 32 to 43 picofarads and were found to be ineffective.

When a rectangular pulse is applied to the pulse transformer, the high permeability core quickly goes into saturation and produces a short positive spike in the secondary winding corresponding to the leading edge of the applied pulse. Similarly, the trailing edge of the applied pulse produces a sharp negative spike on the secondary winding. The rise time for the spikes is on the order of 100 nanoseconds. With these short time delays the pulse transformer according to the invention can be used to pass information for pulses in the range of 6000 to 20000 Hz with minimal radiation and noise losses.

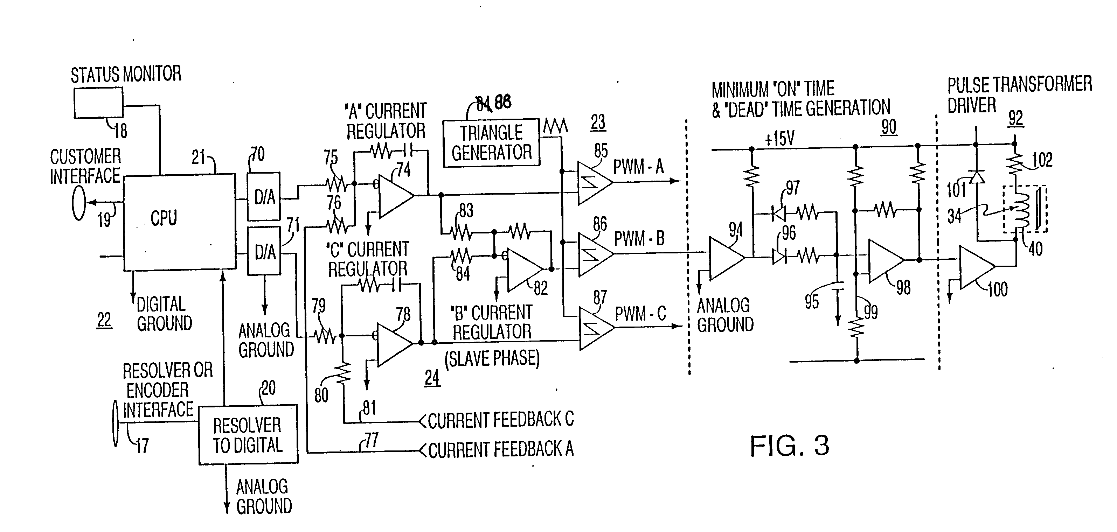

Fig. 3 is a schematic diagram illustrating the electronic sections of the motor controller connected to supply the primary winding of pulse transformer **34**. These sections include the central processing unit (CPU) **21** and other digital components in digital section **22**. Also included is the pulse width modulator (PWM) **23** and other analog components in the analog section **24.**

The central processing unit **21** can be a microprocessor or other type of digital processing electronics. The CPU receives rotor position information from the motor being controlled via a resolver or position encoder **17** which provides rotor position information. The rotor position information is converted to a digital form by a resolver-to-digital converter **20**. The position information is used to commutate the winding excitation calculated by the CPU according to rotor position. The position information can also be used for a servo loop positioning of the motor shaft. Also, the CPU can calculate motor speed from the rate of change of the rotor position. The CPU receives data from a status monitor **18** which provides status information for any parameter being controlled and is useful in calculating the motor excitation. A customer interface **19** provides command information such as the desired speed, desired torque or desired position.

If the motor controller is operated as a velocity servo, for example, the CPU is programmed to compare the speed command with the feedback signal indicating actual speed to determine the torque required to achieve the desired speed. Likewise, servo position control can be achieved by comparing the desired position to the actual position to determine the motor torque required to reach the desired position. The CPU calculates an incrementally synthesized excitation signal including the frequency, phase and amplitude of the current excitation to be supplied to the motor. The CPU furnishes such a sinusoidal signal to a digital-to-analog (D/A) converter **70** for controlling the excitation at one phase of the motor. A second such signal, displaced by 120 electrical degrees, is supplied to another D/A converter **71** to control excitation for a second motor phase. The third phase is the sum of the other two phases and, therefore, need not be calculated by the CPU.

D/A converters **70** and **71** provide sinusoidal excitation signals to the PWM stage **23** which converts the excitation signals into pulse trains wherein the pulse width is proportional to the instantaneous signal amplitude. The pulse width determines the turn-on and turn-off times for the power transistor controlling current flow to the motor windings.

As described hereinafter, current sensors are provided for sensing the current flow to the motor windings to provide corresponding voltage feedback signals **77** and **81**. The feedback signal voltages are compared with the desired excitation signal values calculated by the CPU. The comparison of the calculated value for phase A and the actual feedback value of the current are compared and the result of the comparison appears as the output of amplifier **74.** Similarly, the feedback signal **81** is applied to the summing junction of amplifier **78** for comparison with the calculated signal applied to resistor **79** so that the results of the comparison appear at the output of amplifier **78**. The signals for phase A and C at the outputs of amplifiers **74** and **78**, respectively, are summed in operational amplifier **82** and summing resistors **83** and **84.** Since the amplifiers **74** and **78** produce signals displaced by 120 electrical degrees, the remaining phase B is derived by summing phases A and C in amplifier **82.**

The PWM pulse train is generated by comparing the excitation signal value from one of amplifiers **74, 78** and **82** to a triangular waveform value generated by triangle generator **88.** The signal value comparisons are achieved by comparators **85, 86** and **87** for phases A, B and C, respectively. More specifically, the excitation signal value for phase A is compared with triangle waveform generator **88** such that when the excitation signal value is below the triangular wave value, the output of comparator **85** is ON, and when the signal value is above the triangular wave value, the output of comparator **85** is OFF. The greater the excitation signal value, the wider the pulse emerging from comparator **85** and, therefore, the greater the current supplied to the motor winding. The smaller the signal value, the narrower the pulse and the smaller the current supplied to the motor winding. PWM pulse trains for phases B and C are generated in similar fashion.

The base frequency for the triangular wave in most current systems is on the order of 2000 Hz or less. In the motor controller according to the invention, the repetition rate of the triangular wave can be in the range of 6000 to 20000 Hz. The higher to frequency of the PWM pulses the smoother the control and the smaller the size of the components. Higher PWM frequencies can be employed using the same pulse transformers by using faster Schmitt triggers and gate drives.

To simplify the illustration, only the phase B section for the "dead" time generation unit **90** and the pulse transformer driver **92** are shown in Fig. 3. An actual system would include similar circuits **90** and **92** for each of the three phases.

The minimum "ON" time and "DEAD" time generator **90** includes a comparator **94** which receives the PWM signal. A capacitor **95** is coupled to the comparator output by a charging path through diode **96** and a discharging path through diode **97**. When the pulse signal supplied by comparator (amplifier) **94** goes positive, capacitor **95** is charged to this value very rapidly via forward biased diode **96.** Subsequently, when the output of comparator (amplifier) **94** drops to zero, capacitor **95** discharges via diode **97.** The voltage stored in capacitor **95** is supplied to one input of comparator **98** for a Schmitt trigger comparison with the voltage on a voltage divider **99**. The parameters of the circuit are adjusted to provide a turn-on delay to ensure that there will be no "shoot through" where both power transistors of a complimentary pair are conductive at the same time. The circuit also protects against "double pulsing" where a transistor receives a turn-off pulse when it is only partially turned on. To avoid such double pulsing, the circuit delays the subsequent turn-off pulse until 2 microseconds after the turn-on pulse.

Comparator (amplifier) **98** supplies the PWM pulse train to the primary winding **40** of pulse transformer **34** via an amplifier **100** which functions as a driver for the pulse transformer. Primary winding **40** is connected to the positive supply through a resistor **102.** A diode **101** is connected across the series combination of resistor **102** and winding **40**. The purpose of the diode is to bypass inductive spikes.

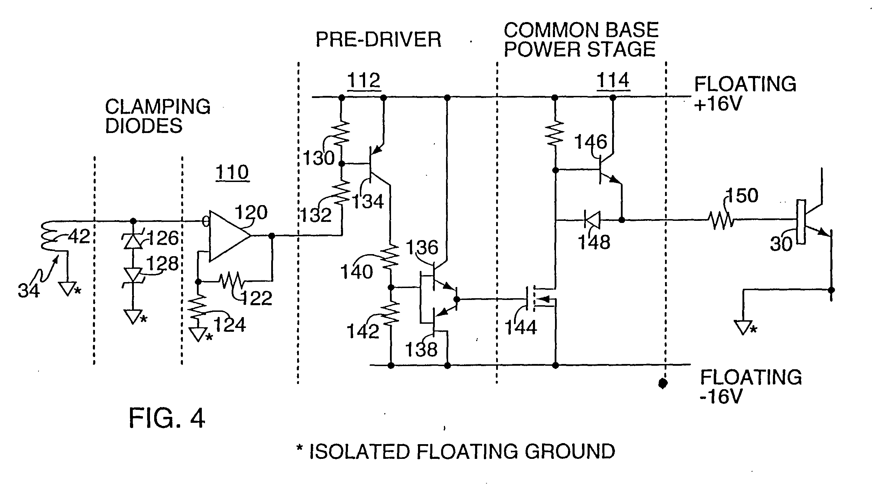

The power stages connected to the secondary winding **42** of the pulse transformer **34** are shown schematically in Fig. 4. The power stages include a Schmitt trigger **110** used to reconstruct the PWM pulses, a predriver stage **112** for amplifying the PWM pulses and a common base power stage **114** which provides the driving signal for the fate of the main power transistor **30.**

Power transistor **30** is an isolated gate bipolar transistor (IGBT). Such transistors are intended to operate either in the saturated ON state of the blocked mode OFF state. The IGBT transistor is turned on by the application of a pulse to the gate and thereafter remains in the conductive state until pulsed in the opposite direction.

Schmitt trigger **110** includes a comparator **120** with a resistor **122** connected from the output to the plus input of the comparator. The plus input is also connected to ground via a resistor **124.** Secondary winding **42** of the pulse transformer is connected between the negative input of the comparator **120** and ground. A pair of Zener diodes **126, 128** is connected across secondary winding **42**. The ratio of resistors **122** and **124** can be set to have trigger points at +8V and -8V. However, the trigger points are not critical and can be in the range of 1V to 14V.

In the operation of the Schmitt trigger assume that the output of comparator **120** is initially negative and that the positive input is, therefore, set to -8V. When a positive pulse appears on the transformer secondary winding **42** and exceeds the value of +8V, the circuit triggers to the ON state. In the ON state where the comparator output is +15V, the plus input shifts to +8V. The comparator output stays positive until such time as a negative pulse appears on secondary winding **42** and exceeds-8V. At this point, the trigger circuit reverts to the initial OFF state. In this fashion, the spike pulses passing through the pulse transformer corresponding to the leading and trailing edges of the PWM pulses are effective to reconstruct the PWM pulse.

In order to get maximum rise time, it is desirable that the pulse transformer produce spike pulses exceeding 15 V. Zener diodes **126, 128** limit the voltage appearing at the comparator input to protect the circuit components.

The predriver circuit **112** includes a PNP bipolar transistor **134** and two transistors **136** and **138** interconnected in totem-pole fashion. The base of transistor **134** is connected to the junction of resistors **130** and **132** connected between the plus supply and the output of comparator **120.** The emitter of transistor **134** is connected to the +16V supply and the collector is connected to the -16V supply via series resistors **140** and **142.** The junction of resistors **140** and **142** is connected to the bases of transistors **136** and **138.** Transistors **134, 136** and **138** increase the pulse current sufficiently to drive the MOSFET power stage which, in turn, drives the gate of IGBT transistor **30.** MOSFET transistor **144**, connected between the +16V supply and the -16V supply, generates a voltage pulse of sufficient magnitude to render transistor **30** fully conductive in the saturated state.

Power stage **114** further includes transistor **146** between the plus supply and the gate of power transistor **30**. Transistor **146** has a low collector-emitter voltage when in the conductive state and, therefore, serves to drive power transistor **30** into the hard saturation state when transistor **146** is conductive. Diode **148** connected across the emitter-base junction of transistor **146** protects against reverse bias and maintains the power transistor **30** in the blocking mode when in the OFF state.

The motor controller according to the invention is designed to operate in the range of 6000 to 20000 Hz PWM switching rates. To achieve operation at these frequencies, it is necessary to have very fast ON/OFF switching for the PWM pulses. Pulse transformer **34** can transfer pulses with a propagation time delay of less than **100** nanoseconds in either direction. The pulse transformer, Schmitt trigger and gate drive together can transfer PWM pulses in less than **700** nanoseconds for TURN-ON and less than **350** nanoseconds for TURN-OFF. With these TURN-ON and TURN-OFF rates, a PWM pulse rate of 20000 Hz can be achieved. Even higher PWM switching rates can reasonably be achieved by using faster Schmitt trigger circuits and faster predriver and driver stages. Such high speed components are within the range of existing technology, but are relatively costly at present.

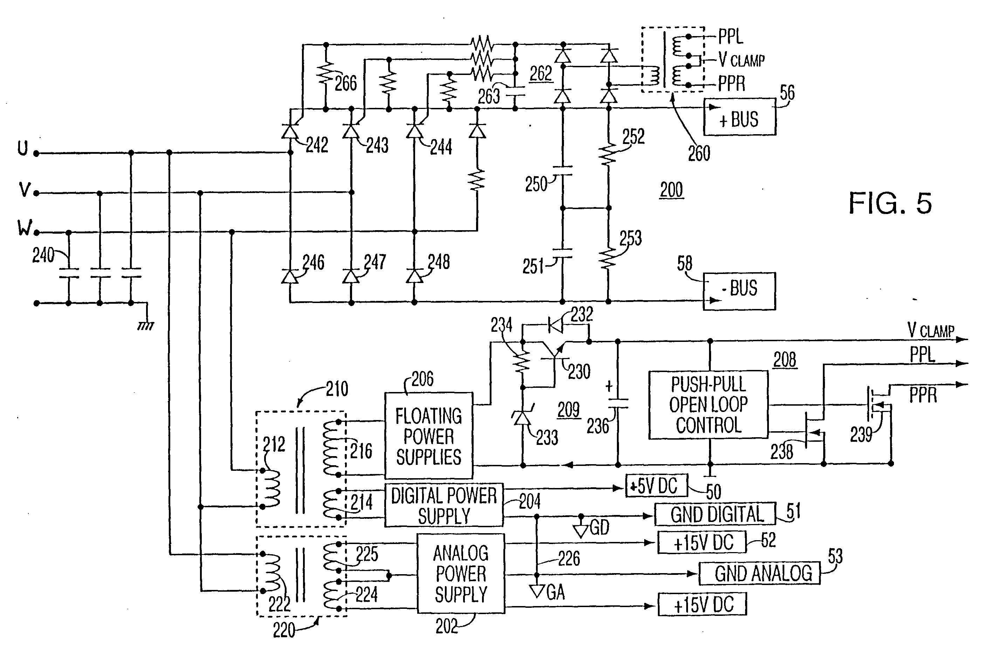

The power for the motor controller is supplied by four power supplies shown schematically in Fig. 5. The four supplies include a main supply **200** which supplies power to the motor windings via the power transistor. Also included is an analog power supply **202,** a digital power supply **204,** and a floating power supply **206,** the latter being used to provide power to the individual gate drives.

Power for the controller is supplied from a three phase source of conductors U, V and W. Capacitors **240** are connected between the conductors and the chassis ground to filter out noise which would otherwise flow back onto the source.

The analog power supply **202** is connected to the source through a transformer **220** which includes a primary winding **222** connected across two of the source conductors U, V and W and a center tapped secondary winding **224-225.** Secondary winding **224-225** is connected to the analog power supply **202** to produce +15V and -15V on conductor 52 (shown in Fig. 1). The center tap of winding **224-225** is connected to analog ground **53.**

Digital power supply **204** is connected to the source through a transformer **210** which includes a primary winding **212** connected across two conductors from a three-phase source. The transformer also includes a secondary winding **214** connected to the digital power supply **204.** The digital power supply produces a +5V on conductor **50** (Fig. 1) relative to digital ground **51.**

The digital power supply is connected to supply the components of digital section **22** as shown in Fig. 1 and the analog power supply is connected to supply the components of analog section **24**. The digital power supply has a ground return path separate from the analog power supply. The two ground return paths are tied together to the supplies such as by connection **226.** Also, the digital power supply and the analog power supply are connected to the source through separate transformers **210** and **220.** By interconnecting the ground returns at the source and by utilizing separate transformers, the two supplies are isolated from one another.

The floating power supply **206** is connected to the source via a secondary winding **216** in transformer **210.** Power supply **206** provides a full wave rectified current to a capacitor **236** in a Zener power clamp circuit **209** and the power stored in the capacitor is supplied to a push-pull oscillator **208.**

The Zener power clamp **209** includes an NPN transistor **230** so connected that the current from the supply passes through the collector-emitter circuit of the transistor to charge capacitor **236.** A Zener diode **233** is connected between the base of the transistor **230** and ground and current flow through the Zener is supplied by a resistor **234** connected across the collector-base of the transistor. A diode 232 is connected across the collector-emitter circuit of the transistor. The Zener diode is selected having a voltage threshold of 14.5 V. In operation, the Zener clamp circuit **209** permits current flow from supply **206** through transistor **230** while the potential across the capacitor is below 15 V. When the potential across the capacitor exceeds the Zener potential and the base-emitter voltage drop of the transistor, the transistor becomes non-conductive. As a result, the circuit clamps the potential across the capacitor at a potential slightly above the Zener potential.

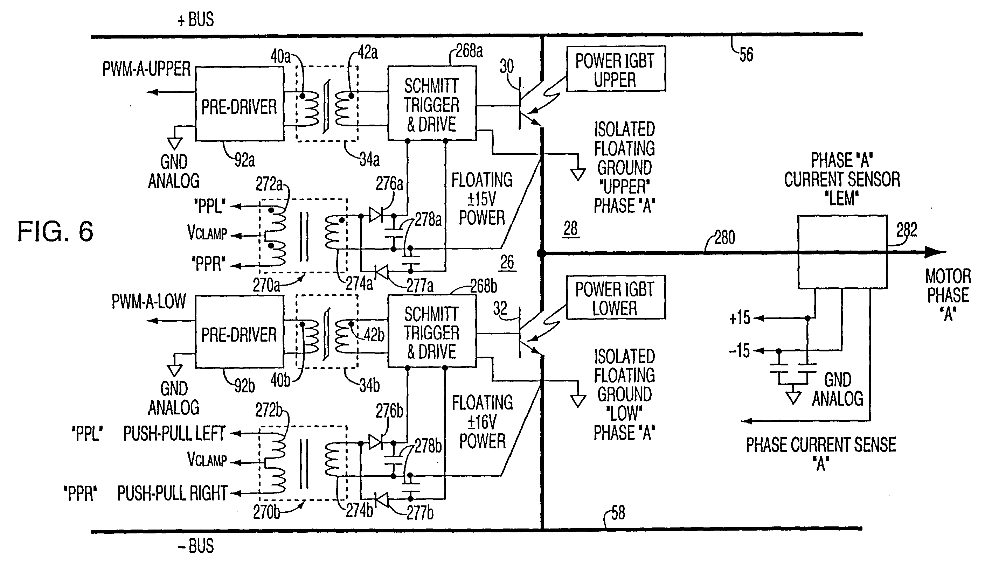

Floating power supply **206** supplies power to the gate drive circuits. The supply to the gate drive circuits is preferable at a relatively high frequency to reduce the size of the isolating transformers (shown in Fig. 6). Accordingly, a push-pull open loop control circuit **208** (Fig. 5) is used which is in the nature of a push-pull oscillator operating at approximately 60 KHz. MOSFET transistors **238** and **239** (Fig. 5) are connected to the oscillator to operate in push-pull fashion such that the transistors alternately become conductive. The result is a pair of output currents designated PPL (Push-Pull Left) and PPR (Push-Pull Right) which are 60 KHz rectangular waves which become positive alternately. PPL, PPR and the V_{clamp} conductors connect to transformers which provide independent floating power to each of the six gate drives for the power transistors supplying the motor as shown in Fig. 6.

As seen in Fig. 5, main supply **200** includes three diodes **246-248** and three SCRs **242-244** connected to form a three phase full wave rectifying bridge. The rectified output is supplied to capacitors **250** and **251** in series with one another between +bus **56** and -bus **58.** A resistor **252** is connected across capacitor **250** and a resistor **253** is connected across capacitor **251.** The capacitors filter out the ripple from the power supply and resistors **252** and **253** provide a discharge path when the supply is turned off.

As also seen in Fig. 5, transformer **260** is connected to supply conductors V_{clamp}, PPR and PPL to charge a capacitor **263** via a full wave bridge rectifying circuit **262**. A potential across capacitor **263** is supplied to the gate elements of SCRs **242-244** via suitable voltage dividers. Capacitor **263** provides a DC filter for removing the high frequency ripple. A soft start for the main power supply can be achieved by delaying the initial operation of push-pull controller **208.**

It is significant that the floating power supplies which power the gate drive circuits and are connected to the secondary windings of pulse transformer **34** (as shown in Figs. 1, 2, 3 and 4) are coupled to the source through transformer **210.** The analog power supply **202** supplies power to the electronic analog circuits **24** (Figs. 1 and 3) which are connected to the primary winding of pulse transformer **34.** The floating power supply **206** and the analog power supply **202** are connected to the source through separate transformers **210** and **220** to thereby provide isolation between circuits on opposite sides of the pulse transformer (Fig. 5).

A separate floating supply is used with each of the gate drive circuits associated with the six IGBT power transistors. A complementary power transistor pair **30** and **32** for Phase A is shown in Fig. 6. Specifically, the collector of the upper transistor **30** is connected to the +bus and the emitter is connected to the phase A motor winding. The collector of lower power transistor **32** is connected to the phase A motor winding as well as the emitter of transistor **30**. The emitter of transistor **32** is connected to the -bus. When a pulse is applied to transistor **30** which is positive at the gate relative to the emitter, transistor **30** becomes conductive and goes into saturation effectively connecting the motor winding to the +bus. On the other hand, if a pulse is applied to the gate of the transistor **32** relative to its emitter, the transistor is driven into saturation and connects the motor winding to the -bus.

Since the drive pulse for transistor **30** is relative to the emitter which can vary from the +bus to the -bus voltages, the drive circuit and the power supply must both be floating. For the upper power transistor, PWM-upper signal for phase A is applied at a predriver **92a** which, in turn, is coupled to the primary winding **40a** of pulse transformer **34a** as previously described in connection with Fig. 2. The secondary winding **42a** of the pulse transformer is connected to the Schmitt trigger and, in turn, to the gate drive in unit **268a.**

A floating supply for the upper gate drive circuit includes a transformer **270a** having a center tapped primary winding **272a**. The center tap of the primary winding is connected to V_{clamp} (see Fig. 5) and the ends of the windings are connected, respectively, to "PPL" and "PPR". One end of the secondary winding **274a** is connected via diodes **276a** and **277a** to provide +16V and -16V, respectively, to the gate drive circuit. The other end of the secondary winding provides the floating ground which is connected to the emitter of transistor **30.** Capacitors **278a** are connected between the floating ground and the diodes **276a** and **277a.** Since the gate drive and the power supply, therefore, are both transformer coupled, the gate drive and the floating power supply can both float according to the potential appearing at the emitter of transistor **30.** The capacitors **278a** filter the supplied voltage and also bypass noise. Common mode noise is rejected because of transformer coupling of transformer **270a.** Common mode noise is further rejected by the transformer **210** coupling the floating supply to the source, as shown in Fig. 5.

A separate floating supply is provided for the lower gate drive transistor **32**. The gate drive is connected between the base and emitter of transistor **32.** A floating supply including transformer **270b** is essentially the same as that including transformer **270a.** +16V and -16V floating power is supplied to the gate drive **268b** and the floating ground is connected to the emitter of transistor **32.**

As shown in Fig. 6, the conductor **280** connecting to phase A of the motor passes through a LEM current sensor **282.** The LEM sensor is powered from the analog component supply. The output of LEM **282** is a voltage proportional to the current passing to the motor. A similar LEM sensor may be placed on each of the conductors energizing the three phase windings of the motor. The current feedback is supplied to comparators **74** and **78** in Fig. 3 via conductors **77** and **81**.

The foregoing description includes a preferred embodiment of the invention. It should be obvious to those skilled in the art that there are many variations and other embodiments contemplated within the scope of the invention as claimed in claims 1 to 7.

## Claims

1. A controller for a brushless motor (10) comprising an electronic pulse width modulator (23) for providing signals indicating pulse width for one or more pulse trains for creating sinusoidal excitation current for one or more phases applied to said brushless motor, a pulse transformer (34) coupled to receive a pulse train from said pulse width modulator (23), one or more power transistors (28) coupled to said brushless motor for controlling current flow to said motor according to the conductive state thereof; and a gate drive (26) coupled to control the conductive state of said power transistors, **characterized in that** said pulse trains have a pulse repetition rate greater than 6000 Hz; said pulse transformer (34) is a saturable pulse transformer having an interwinding capacitance of less than 5 picofarads, and being arranged to pass through voltage spikes corresponding to the leading and trailing edges of pulses in said pulse train indicating pulse width as said saturable pulse transformer goes into and out of saturation; and that said gate drive (26) is connected to said saturable pulse transformer (34) to receive said voltages spikes corresponding to said leading and trailing edges, said gate drive being capable of generating a rectangular pulse having a width corresponding to said leading and trailing edges.

2. The controller of Claim 1 wherein said gate drive includes a Schmitt trigger (35, 36, 37) to generate rectangular pulses having a width corresponding to said leading and trailing edges.

3. The controller of Claim 1 wherein said saturable pulse transformer (34) has an inter-winding capacitance less than 1 picofarad.

4. The controller of claims 1 or 3 including a digital electronic section (22) to determine the amplitude, phase and frequency of the motor excitation current; a high frequency PWM electronic analog section (24) for providing one or more pulse trains with pulse widths corresponding to sinusoidal current excitation for said motor; power transistors (28) for controlling energization of said motor winding in ON/OFF fashion; and a separate gate drive (26a) responsive to one of said pulse trains for each of said power transistors to control the conductive state, wherein the gate drive and power transistors are isolated from said digital and analog power supply connected to supply current to said power transistors for energizing the motor windings according to the pulse widths determined by said PWM section; a separate floating power supply (206) for each of said gate drives coupled to a power source through a first transformer (210), a power supply (52) for said PWM analog section components coupled to the source via a second transformer separate from said first transformer; whereby said isolation between said analog section components and said gate drives is maintained in the respective power supplies (270a, 270b).

5. The controller of claim 4 wherein each of said floating power supplies (206) is supplied from a high frequency oscillator source.

6. The controller of claim 4 further including a power supply (50) for said digital electronic section and wherein said supply for said digital electronic section and said supply for said PWM analog section components connect to the power source through separate transformers.

7. The controller of claim 6 wherein said digital section and said analog section components return through separate ground return paths tied together at the supplies (51, 53).

## Patentansprüche

1. Ein Regler für einen bürstenlosen Motor (10) mit einem elektronischen Pulsbreitewandler (23) zum Liefern von Signalen, die indikativ sind für die Pulsbreite eines oder mehrerer Pulsfolgen zum Erzeugen des sinusförmigen Erregerstroms für eine oder mehrere Phasen des genannten bürstenlosen Motors, einen Puls-Transformator (34), der so geschaltet ist, daß er eine Pulsfolge vom Pulsbreitewandler (23) empfängt, einen oder mehrere mit dem genannten bürstenlosen Motor verbundene Leistungstransistore(en) (28) zum Steuern des Stromflusses zum genannten Motor entsprechend deren Leitfähigkeitsstatus; und eine Gateansteuerung (26), die so verbunden ist, daß sie den Leitfähigkeitsstatus der Leistungstransistoren steuert, **dadurch gekennzeichnet, daß** die genannten Pulsfolgen eine Pulswiederholungsrate von mehr als 6000 Hz aufweisen; und daß der Puls-Transformator (34) ein sättigbarer Puls-Transformator mit einer Zwischenwicklungskapazität von weniger als 5 Picofarad ist, der so angeordnet ist, daß er Spannungsspitzen liefert, die den Anstiegs- und Abfallkanten der Pulse in der genannten Pulsfolge entsprechen und so die Pulsbreite anzeigen, wenn der sättigbare Puls-Transformator in die und aus der Sättigung geht; und daß die Gateansteuerng (26) mit dem sättigbaren Puls-Transformator (34) verbunden ist, um die genannten, den genannten Anstiegs- und Abfallkanten entsprechenden Spannungsspitzen zu empfangen, wobei die Gateansteuerung in der Lage ist, ihrerseits einen rechtwinkligen Puls zu liefern, dessen Breite den genannten Anstiegs- und Abfallkanten entspricht.

2. Der Regler nach Anspruch 1, in welchem die Gateansteuerung einen Schmitt Trigger (35, 36, 37) aufweist zum Erzeugen von rechtwinkligen Pulsen mit einer Breite, die der der genannten Anstiegs- und Abfallkanten entspricht.

3. Der Regler nach Anspruch 1, in welchem der sättigbare Puls-Transformator (34) eine Zwischenwicklungskapazität von weniger als 1 Picofarad aufweist.

4. Der Regler nach den Ansprüchen 1 oder 3 mit einem digitalen Elektronik-Bauteil (22) zum Bestimmen von Amplitude, Phase und Frequenz der Erregerstroms für den Motor; einem hochfrequenten, Pulsbreitemoduliertem (PWM) analogen elektronischen Bauteil (24) zum Liefern eines oder mehrerer Pulsfolgen mit Pulsbreiten, die dem Strom zur sinusförmigen Erregung des Motors entsprechen; Leistungstransistoren (28) zum EIN/AUS-Steuern des Erregerstroms der genannten Motorwicklung; und einen separaten, von einer der genannten Pulsfolgen gesteuerten Gateansteuerkreis (26a) für jeden der genannten Leistungstransistoren zur Kontrolle deren Leitfähigkeitsstatus, wobei die Gateansteuerkreise und die Leistungstransistoren, von der digitalen und analogen Stromversorgung isoliert, verbunden sind, um Strom für die Leistungstransistoren zu liefern, die ihrerseits die Stromversorgung der Motorwicklungen entsprechend den vom genannten pulsbreitemodulierten (PWM) Bauteil festgelegten Pulsbreiten bewirken; eine separate, nicht geerdete Stromversorgung (206) für jeden der genannten Gateansteuerkreise, die über einen ersten Transformator (210) mit einer Stromquelle verbunden ist; eine Stromversorgung (52) für das genannte pulsbreitemodulierte analoge Bauteil verbunden mit der Stromquelle über einen zweiten, vom ersten Transformator getrennten Transformator (220); wobei die Isolierung zwischen den Komponenten des analogen Bereichs und den Gateansteuerungen in den entsprechenden Stromversorgungseinrichtungen (270a, 270b) aufrechterhalten wird.

5. Der Regler nach Anspruch 4, worin jede der nicht geerdeten Stromversorgungseinrichtungen (206) von einem Hochfrequenz-Oszillator versorgt wird.

6. Der Regler nach Anspruch 4, der weiters eine Stromversorgungseinrichtung (50) für das genannte digitale elektronische Bauteil enthält, wobei die Versorgung für die Komponenten des genannten digitalen elektronischen Bauteils und des genannten pulsbreitemodulierten analogen Bauteils mit der Stromversorgungsquelle über getrennte Transformatoren verbunden sind.

7. Der Regler nach Anspruch 6, in dem die Komponenten des digitalen und des analogen Bauteils über getrennte, in den Versorgungseinrichtungen (51, 53) zusammengeführte Erdpfade verbunden sind.

## Revendications

1. Contrôleur pour moteur sans balais (10) comportant un modulateur électronique de largeur d'impulsion (23) pour fournir des signaux représentant une largeur d'impulsion pour un ou plusieurs trains d'impulsions pour engendrer un courant d'excitation sinusoïdal pour une ou plusieurs phases appliqué au moteur sans balais, un transformateur d'impulsions (34) couplé pour recevoir un train d'impulsions provenant du modulateur de largeur d'impulsions (23), un ou plusieurs transistors de puissance (28) couplés au moteur sans balais pour commander le flux de courant vers le moteur selon leur état de conduction, et un circuit de commande de grille (26) couplé pour commander l'état de conduction des transistors de puissance, caractérisé par le fait que les trains d'impulsions ont une fréquence de répétition supérieure à 6000 Hz, le transformateur d'impulsions (34) est un transformateur d'impulsions saturable ayant une capacité interbobinages inférieure à 5 picofarads et étant agencé pour laisser passer des pics de tension correspondant aux fronts avant et arrière des impulsions du train indiquant des largeurs d'impulsion lorsque le transformateur d'impulsions saturable passe à l'état saturé et en sort, et le circuit de commande de grille (26) est connecté au transformateur d'impulsions saturable (34) pour recevoir les pics de tension correspondant aux fronts avant et arrière, le circuit de commande de grille étant agencé pour engendrer une impulsion rectangulaire de largeur correspondant auxdits fronts avant et arrière.

2. Contrôleur selon la revendication 1, dans lequel ladite grille comporte un déclencheur de Schmitt pour engendrer des impulsions rectangulaires de largeur correspondant aux fronts avant et arrière.

3. Contrôleur selon la revendication 1, dans lequel le transformateur d'impulsions saturable (34) a une capacité interbobinages inférieure à 1 picofarad.

4. Contrôleur selon l'une des revendications 1 et 3, comportant une section électronique numérique (22) pour déterminer l'amplitude, la phase et la fréquence du courant d'excitation du moteur, une section électronique analogique PWM à haute fréquence (24) pour fournir un ou plusieurs trains d'impulsions ayant des largeurs d'impulsions correspondantes au courant d'excitation sinusoïdal pour le moteur, des transistors de puissance (28) pour commander l'alimentation d'énergie du bobinage moteur en mode passant/bloqué, et une commande de grille séparée (26a) sensible à l'un desdits trains d'impulsions pour chacun des transistors de puissance pour commander l'état conducteur, dans lequel le circuit de commande de grille et les transistors de puissance sont isolés par rapport aux alimentations pour le numérique et l'analogique reliées pour fournir du courant aux transistors de puissance d'alimententation des bobinages moteur selon les largeurs d'impulsions déterminées par la section PWM, une alimentation flottante séparée (206) pour chacun des circuits de commande de grille couplée à une source d'alimentation à travers un premier transformateur (210), une source d'alimentation (52) pour les composants de la section analogique PWM couplée à la source via un second transformateur séparé du premier transformateur, pour que ledit isolement entre les composants de la section analogique et les circuits de commande de grille soit maintenue dans les alimentations respectives (270a, 270b).

5. Contrôleur selon la revendication 4, dans lequel chacune des alimentations de courant (206) est fournie à partir d'une source oscillateur à haute fréquence.

6. Contrôleur selon la revendication 4, comportant en outre une source d'alimentation (50) pour la section électronique numérique et dans lequel l'alimentation de la section électronique numérique et l'alimentation pour les composants de la section analogiques PWM sont reliées à la source d'alimentation à travers des transformateurs séparés.

7. Contrôleur selon la revendication 6, dans lequel les composants de la section numérique et de la section analogique ont un retour à la masse par des chemins séparés reliés ensemble au niveau des alimentations (51, 53).
